(19) Europäisches Patentamt
European Patent Office
Office européen des brevets

(11) **EP 4 310 666 A1**

(12) **EUROPEAN PATENT APPLICATION**

(43) Date of publication:
**24.01.2024 Bulletin 2024/04**

(21) Application number: **22382683.5**

(22) Date of filing: **18.07.2022**

(51) International Patent Classification (IPC):
**G06F 7/483** $^{(2006.01)}$    **G06F 7/58** $^{(2006.01)}$

(52) Cooperative Patent Classification (CPC):
**G06F 7/483;** G06F 7/588

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Quside Technologies S.L.**
**08860 Barcelona (ES)**

(72) Inventors:
• **Ramón Martínez Saavedra, José**
  **Castelldefels (ES)**
• **Abellán Sánchez, Carlos**
  **Castelldefels (ES)**

(74) Representative: **Grünecker Patent- und**
**Rechtsanwälte**
**PartG mbB**
**Leopoldstraße 4**
**80802 München (DE)**

(54) **COMPUTER-IMPLEMENTED METHOD FOR TRANSFORMING A BIT STREAM INTO A FLOATING POINT NUMBER**

(57) Computer-implemented method comprising obtaining a bit stream and transforming the bit stream into a floating-point number, wherein the floating-point number comprises an exponent and a significand, the transformation comprising determining the exponent of the floating-point number based on counting a number of bitwise shifts needed to obtain a bit value of 1 at a designated position of the bit stream, the transformation further comprising determining the significand of the floating-point number based on a certain number of bits that are different from the bits used for determining the exponent.

FIG. 1

**EP 4 310 666 A1**

## Description

The present invention relates to a computer-implemented method for transforming a bit stream into a floating-point number according to independent claim 1 and a computing system adapted to transform a bit stream into a floating-point number according to independent claim 15.

## Prior art

In order to represent decimal numbers, computers generally utilize either a fixed-point or a floating-point format.

A floating-point number $f$, for instance, can be expressed as

$$f = (-1)^s \cdot m \cdot b^e,$$

where $(-1)^s$ specifies the sign, $m$ the significand, $b$ the base, and $e$ the exponent of the floating-point number. As most computers nowadays are binary machines, they process floating-point numbers using a binary representation, where the base of the floating-point number is given by $b = 2$.

The most common standard used by computers to represent floating-point numbers is the IEEE-754 standard. This standard specifies that the floating-point number comprises a single sign bit and, depending on the precision of the floating-point number, a particular number of bits to express the exponent and a particular number of bits to express the significand. A single-precision floating-point number, for instance, has a precision of 32 bit, whereby the sign bit comprises a single bit, the exponent comprises 8 bit, and the significand comprises 23 bit.

In certain cases, computers have to transform a stream of binary digits into a sequence of floating-point numbers with particular precision. This can, for instance, be the case when a computer obtains a stream of uniformly distributed random binary digits from a physical random bit generator and has the task of transforming the bit stream into a sequence of uniformly distributed floating-point numbers. Using, for example, a representation in the IEEE-754 standard, a computer performs this task by shifting a window, having the same size as the floating-point numbers to be generated, in steps of the size of the floating-point number over the bit stream and transforming the fixed number of bits located inside the window into a floating-point number. The number of floating-point numbers that can be generated from the bit stream is thus defined by the precision of the floating-point numbers to be generated and particularly the format used for the floating-point numbers, as this defines the size of the sliding window.

## Technical problem

With respect to the available prior art, the technical problem addressed by the present invention is to provide a method for transforming a bit stream into one or more floating-point numbers, whereby the method allows obtaining, on average, a larger number of floating-point numbers of certain precision from the bit stream.

## Solution

This problem is solved by the computer-implemented method according to independent claim 1 and the computer system according to independent claim 15. Preferred embodiments are provided in the dependent claims.

The computer-implemented method according to the invention comprises obtaining a bit stream and transforming the bit stream into a floating-point number, wherein the floating-point number comprises an exponent and a significand, the transformation comprising determining the exponent of the floating-point number based on counting a number of bitwise shifts needed to obtain a bit value of 1 at a designated position of the bit stream, the transformation further comprising determining the significand of the floating-point number based on a certain number of bits that are different from the bits used for determining the exponent.

The significand can also be referred to as mantissa. In general, both terminologies are used interchangeably.

With the bit stream obtained by the computer-implemented method, a stream of binary digits is meant, each digit having either a value of 0 or 1. Preferably, the bit stream comprises a stream of (uniformly distributed) random binary digits. Such a stream of (uniformly distributed) random binary digits can, for instance, be obtained from an independent and identically distributed random bit generator, such as a physical random bit generator comprising a vertical-cavity surface-emitting laser or comprising a quantum phase-diffusion scheme, as examples. Random binary digits can also be generated by using two lasers, whereby one laser is operated in constant mode and the other laser in pulsed mode. When the laser in pulsed mode is alternatingly driven below and above its lasering threshold, the relative phase relation between its laser pulses and the constantly driven laser is random and facilitates the generation of (uniformly distributed) random binary digits. The method is, however, not limited to a stream of (uniformly distributed) random binary digits. It can also be applied to transform, for instance, a stream of non-random binary digits, a stream of pseudo-random binary digits, or a stream comprising an arbitrary combination of random, pseudo-random and/or non-random binary digits into one or more floating-point numbers.

The designated position can be any position of a bit of the bit stream. It can be the first bit of the bit stream (either from the left or the right) or any other bit in between. Particularly, if more than one floating-point number is to be obtained from the bit stream, the designated bit for a first floating-point number to be determined may be the first bit of the bit stream (either from the left or the right) and the designated position for a subsequent floating-point number to be determined may be a bit (immediately) to the right or to the left of the last bit used for obtaining the immediately preceding floating-point number.

The bitwise shifts can comprise left shifts or right shifts and may preferably comprise a single one-bit-shift per bitwise shift, though shifting more than one bit per shift is also encompassed by the present disclosure. In one embodiment, the bitwise shifts that are carried out by the method in order to obtain a bit value of 1 at the designated position of the bit stream are of the same type. This means that when, for instance, the first bitwise shift carried out by the method is a right shift, also all following bitwise shifts carried out to obtain a bit value of 1 at the designated position of the bit stream are right shifts. Alternatively, when the first bitwise shift of the bit stream is a left shift, also all following bitwise shifts carried out to obtain a bit value of 1 at the designated position of the bit stream are left shifts.

Optionally, the method may comprise a reshuffling of the bit stream, which may take place after obtaining the bit stream and before determining the exponent. Such a reshuffling of the bit stream may comprise a random reshuffling, a pseudo-random reshuffling or a non-random reshuffling, as for instance a hash operation. By reshuffling the bit stream in the above-described manner, an additional security aspect can be implemented into the method, as the bit stream used for the determination of the exponent and the significand, differs from the bit stream originally obtained by the method. This may, for instance, be of relevance when the bit stream is a stream of uniformly distributed random bits and intended, for instance, for the generation of a random secret password.

Instead of using a fixed number of bits of the bit stream to determine the exponent of the floating-point number, the method according to the invention dynamically determines the number of bits of the bit stream necessary to specify the exponent of the floating-point number, by carrying out bitwise shifts of the bit stream until a bit having a value of 1 is obtained at the designated position of the bit stream. As, at least for a uniformly distributed random bit stream, the chance of a bit to have a value of 1 is 50%, the number of shifts needed starting from a designated position will usually be 0 (in case the bit at the designated position is already 1), 1 or 2 in most of the cases (87.5%). Using this bit for example as the most significant bit for determining the exponent of a floating-point number of 32 bit thus reduces the number of bits needed for the exponent by at least 5 on average, in most cases. Thereby, the amount of bits used to obtain, for example, a 32 bit floating-point number is significantly reduced compared to the prior art, thereby allowing to obtain more floating-point numbers from a bit stream of given length while the precision of these floating-point numbers is not reduced.

Advantageously, the method also reduces energy consumption, as the generation of a particular number of floating-point numbers requires, on average, to obtain a smaller number of bits from a bit source, which can, for instance, be a physical random bit generator. The fewer bits that have to be generated, the less energy has to be consumed by the physical random bit generator and therefore the less energy is required to generate a floating-point number.

As the designated position of the bit stream, any bit position of the bit stream can be specified. The designated position of the bit stream can, for instance, be the most significant position of the bit stream (or the leftmost bit) or the least significant position of the bit stream (or the rightmost bit). However, also any other bit position located in between the most significant position and the least significant position of the bit stream may be chosen as the designated position of the bit stream.

In one embodiment, the certain number of bits comprises bits preceding the bit at the designated position of the bit stream or the certain number of bits comprises bits subsequent to the first bit, starting from the designated position of the bit stream, having a value of 1. This ensures that the certain number of bits used for the determination of the significand are different from the bits used for the determination of the exponent. Consequently, there is no correlation between the floating-point number's exponent and significand, which is, for instance, of relevance when a stream of uniformly distributed random binary digits shall be transformed into a stream of uniformly distributed floating-point numbers. The certain number of bits preceding the bit at the designated position can be a sequence of consecutive bits; however, also a sequence of non-consecutive bits is conceivable. The same holds for the certain number of bits, subsequent to the first bit, starting from the designated position of the bit stream, having a value of 1.

In a further embodiment, the bitwise shifts can be left shifts and the certain number of bits comprises bits immediately preceding the bit at the designated position of the bit stream or the certain number of bits comprises bits immediately subsequent to the first bit, starting from the designated position of the bit stream, having a value of 1. This is, for instance, conceivable when the designated position of the bit stream is specified as the most significant position of the bit stream. The bitwise shifts can also be right shifts and the certain number of bits comprises bits immediately subsequent to the bit at the designated position of the bit stream or the certain number of bits comprises bits immediately preceding the first bit, starting from the designated position of the bit stream, having a value of 1. This can, for instance, be the case when the designated position of the bit stream is chosen to be the least significant position of the bit stream.

In an alternative embodiment, the certain number of bits comprises a first certain number of bits preceding the bit at the designated position of the bit stream and a second certain number of bits subsequent to the first bit, starting from the designated position of the bit stream, having a value of 1. This allows, for instance, the efficient use of the bits of the bit stream also for the case where the designated position is close to the most significant position of the bit stream and the bits preceding the bit at the designated position of the bit stream, or the bits subsequent to the first bit subsequent to the bit at the designated position of the bit stream having a value of 1, would not be sufficient to specify the significand of the floating-point number. This may be advantageous in embodiments where the designated position is randomly chosen.

In a further embodiment, the value of the exponent is a given fixed value in case the number of bitwise shifts equals a threshold value. With this, it is ensured that an exponent can be generated by the method, even in case the number of bitwise shifts needed to obtain a bit value of 1 at the designated position of the bit stream is, for instance, too large to be represented by the number of bits of the floating-point number reserved for the exponent, or in case the bit stream would only comprise bits with a value of 0. The threshold value can, for example, be equal to the number of bits used for the exponent in a given format of a floating-point number. For example, the threshold value can be 8. The given fixed value can be arbitrarily chosen and can be, by default, 1 or 0. Alternatively, if the threshold value is reached, the given fixed value may be a randomly determined value that is determined independent from the bit stream itself and thus also considered as a given fixed value within the present disclosure. Alternatively, in case the threshold value is reached, the value of the exponent may be fixed by default to its lowest possible value, which facilitates the generation of subnormal floating-point numbers.

In a further embodiment, the floating-point number comprises a sign. Including a sign doubles the range of possible floating-point numbers that can be generated from the bit stream and also allows to generate negative floating-point numbers, which can be advantageous for certain embodiments of the method, for example, when a subsequent process requires random numbers in a range [-1;1] or any other range comprising positive and negative numbers.

In a further embodiment, the transformation comprises determining the sign of the floating-point number based on a value of a sign bit preceding the bit at the designated position of the bit stream or subsequent to the first bit, starting from the designated position of the bit stream, having a value of 1. This ensures that the bit used to determine the sign of the floating-point number is different from the bits used for determining the exponent of the floating-point number. It, however, leaves open as to whether the bit used for the determination of the sign of the floating-point number was already used for determining the significand or not. With respect to certain embodiments, it can be preferable that the sign bit is further different from the bits used for the determination of the significand. This can, for instance, be the case when a bit stream of uniformly distributed binary digits shall be transformed into a sequence of uniformly distributed floating-point numbers, as in this special case no correlation between the sign and the significand of the floating-point number shall exist.

In a further embodiment, the sign of the floating-point number is positive in case the value of the sign bit is a 0 and negative in case the value of the sign bit is a 1 or, wherein the sign of the floating-point number is positive in case the value of the sign bit is a 1 and negative in case the value of the sign bit is a 0. As compared to the IEEE-754 standard, the method therefore also provides a second alternative representation for the sign bit.

In a further embodiment, determining the exponent further comprises determining a difference between the number of bitwise shifts and a bias value. This allows determining both positive and negative exponent values from a bit stream, which in turn allows generating floating-point numbers having either a positive or a negative exponent. Consequently, the bit stream can, for instance, be transformed into a positive or negative floating-point number having a value smaller or larger than 1 in decimal notation.

In a further embodiment, determining the exponent further comprises incrementing the number of bitwise left shifts needed by one.

In a further embodiment, the number of bits of the bias value can depend on a format of the floating-point number. In a further embodiment, the certain number of bits used to determine the significand can depend on the format of the floating-point number. Format of the floating-point number means a standardized specification of the floating-point number, which provides distinct information on the floating-point number, such as the number of bits being reserved for its exponent or significand.

In a further embodiment, a size of the floating-point number is a half, a single, a double, a quadruple or an octuple. A half specifies a floating-point number with a precision of 16 bit, a single has a precision of 32 bit, a double a precision of 64 bit, a quadruple a precision of 128 bit and an octuple a precision of 256 bit. The computer-implemented method is, therefore, adapted to generate floating-point numbers of commonly known sizes. It is, however, not limited to floating-point numbers having one of the above-specified sizes, as it may transform a bit stream into a floating-point number of any size.

In a further embodiment, the format of the floating-point number is a minifloat or a bFloat. The method is consequently also adapted to transform the bit stream into floating-point numbers of less common formats. It is, however, not limited to generating floating-point numbers of the above-mentioned formats and can also transform the bit stream into a floating-point number with a format that has not been explicitly listed here.

The computing system according to the invention is adapted to execute a computer-implemented method according to any of the embodiments described above. The computing system can, for instance, comprise a central processing unit, a memory and a graphics processing unit. Alternatively, the computing systems may comprise a field programmable gate array (FPGA), a dedicated chip hardware implementation, or any other hardware/software suitable for or specifically adapted to carry out a method according to any of the above embodiments.

The computing system is adapted to carry out the method according to any of the embodiments detailed above. Running the method according to any of the embodiments described before on a computing system allows obtaining the advantages of the method, which includes, for instance, saving computing costs and/or energy consumption.

**Brief description of the drawings**

Figure 1        shows a flow chart of a method according to one embodiment

Figures 2a-d    illustrate bit streams, whereby the bits used for the determination of the significand and the exponent according to different embodiment are indicated.

Figure 3a-c     show bit streams, whereby the bits used for the determination of the sign, the significand and the exponent according to different embodiments are indicated.

Figure 4        illustrates the transformation of a bit stream into a single precision floating-point number according to an embodiment.

**Detailed description of the drawings**

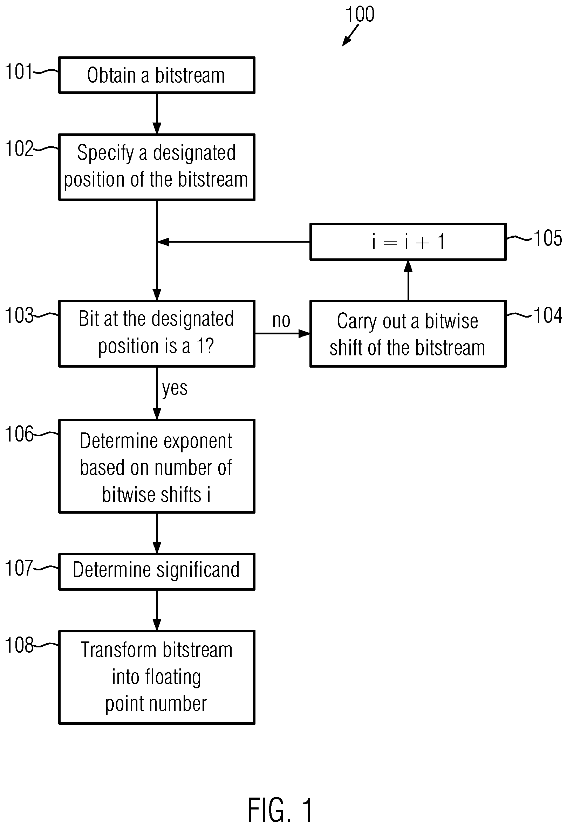

Figure 1 shows a flow chart, which illustrates a computer-implemented method 100 according to an embodiment of the invention for determining a floating-point number from a bit stream. According to the flow chart, the first step 101 of method 100 is to obtain a bit stream. The method may be carried out by a general-purpose computer comprising a processor and memory and optionally a graphics processing unit. Alternatively, the method may be carried out on a computing system comprising a FPGA, a dedicated chip hardware implementation or any other hardware/software suitable for or specifically adapted to carry out the herein described method. The obtaining of the bit stream may comprise receiving the bit stream via a receiver of the computer. For example, if the bit stream is generated external to the computer by a bit stream generator (like a physical random bit generator), the computer may be connected to the bit stream generator via a USB connection or the like connection for data transfer. The obtaining of the bit stream may alternatively comprise the obtaining of the bit stream from a bit stream generator residing inside the computer and which may be realized as an algorithmic bit stream generator or a dedicated physical random bit generator. In such a case, the obtaining of the bit stream may comprise the provision of the bit stream from the algorithmic bit stream generator or the dedicated physical random bit generator to a program or physical entity carrying out method 100.

The bit stream can either be obtained continuously (i.e. one bit after the other over time) or the bit stream can be obtained as a complete bit stream at one point in time.

In a preferred embodiment, the bit stream comprises a stream of uniformly distributed random binary digits. Such a bit stream may, for instance, be obtained from an independent and identically distributed random bit generator, such as a physical random bit generator. A physical random bit generator is an entity that makes use of inherently random processes, like for example the phase relation of two laser diodes where one laser diode is driven in constant mode and the other laser diode is driven in pulsed mode where the pulsed mode comprises the driving of the laser diode shortly below the lasering threshold and shortly above the lasering threshold, thereby randomly generating laser pulses. As the generation of a laser pulse and the phase of this pulse are/is governed by the rules of quantum mechanics, prediction of the relative phase relation of the laser pulses relative to the constantly driven laser diode is inherently random and unpredictable. Also, other physical random bit generators exist that can be used together with the invention.

Alternatively, the bit stream may also comprise a stream of pseudo-random digits, which may be obtained from an algorithmic random bit generator, or a stream of non-random binary digits. It is also conceivable that the obtained bit stream comprises a combination of uniformly distributed random binary digits, pseudo-random binary digits and/or non-random binary digits.

After obtaining the bit stream, the method proceeds with step 102, which comprises specifying a designated position of the bit stream.

In a preferred embodiment, the designated position of the bit stream is specified as the most significant or the least significant position of the bit stream. However, the designated position may also be specified as any other position of the bit stream, which may, for instance, be randomly determined by a computing system on which the method is being carried out or by a user via a user interface of the computing system.

Particularly, if method 100 is executed more than once, the designated position for a first to be determined floating-point number may be at a first position (for example the above-mentioned most significant bit of the bit stream). For a subsequent to be determined floating-point number, a bit may be chosen as designated position that does not belong to the bits used to determine the first floating-point number and so on. Preferably, upon continued execution of the method 100 for a bit stream of given length (for example $10^9$ or $10^{12}$ bit), there is no designated position selected at a bit that has already been used to determine a floating-point number from the bit stream.

After the designated position of the bit stream has been specified, the method checks in step 103 whether the bit at the designated position of the bit stream has a value of 1.

In case the bit at the designated position of the bit stream has a value of 1, the method proceeds with step 106, which comprises determining the exponent of the floating-point number based on a number of bitwise shifts needed to obtain a value of 1 at the designated position of the bit stream. In the current case, where the bit at the designated position of the bit stream has a value of 1, without the need of carrying out a bitwise shift, the method determines the exponent based on an initial value of the number of bitwise shifts carried out, which may optionally be initialized before carrying out step 103. In one embodiment, the initial value of bitwise shifts carried out is preferably initialized to a value of 0 in decimal notation. In an alternative embodiment, it is conceivable that the initial value of bitwise shifts carried out may comprise a bias value.

In the alternative case, where the bit at the designated position of the bit stream has a value of 0, the method enters a loop and proceeds with step 104, which comprises carrying out a first bitwise shift of the bit stream. In the preferred embodiment, the bitwise shift is a left shift, for example in case the most significant position of the bit stream is specified as the designated position of the bit stream, or a right shift, for example in case the least significant position of the bit stream is specified as the designated position of the bit stream. In an alternative embodiment, where the designated position of the bit stream is specified to be a position located somewhere in between the most significant and the least significant position of the bit stream, the bitwise shift can either be a left or right shift.

However, once the bitwise shift was specified as a left or a right shift, any bitwise shift carried out subsequently for determining this floating-point number, preferably is of the same type. It is noted that for determining a subsequent floating-point number, the direction of bitwise shifts can be different compared to the direction of shifts for determining the preceding floating-point number. Particularly, in some embodiments, the direction of shifts can be randomly chosen before performing step 102. Depending on whether left or right shifts are to be used in step 104, the designated position may then be set so as to make sure that no bits for determining the floating-point number are used that have already been used for any preceding floating-point number.

After performing a bitwise shift of the bit stream, the method proceeds with step 105 and may increment a counter i for the number of bitwise shifts carried out by one. The method then proceeds with step 103 and checks whether the bit at the designated position of the bit stream now has a value of 1. If this is the case, the method proceeds with step 106 and determines the exponent of the floating-point number based on the number i of bitwise shifts carried out by the method. In case the bit at the designated position of the bit stream still has a value of 0, the method goes back into the loop and carries out again steps 103, 104 and 105 until a bit having a value of 1 is obtained at the designated position of the bit stream. In some embodiments, instead of carrying out the loop until a bit with a value of 1 is obtained at the designated position, the method may comprise carrying out the bitwise shifts until the number i of bitwise shifts reaches a threshold value. This threshold value may, for instance, be based on the format of the floating-point number into which the bit stream shall be transformed. Preferably, the threshold value specifies a number of bitwise shifts that is at most equal to the number of bits that would be used for the exponent according to the format of the floating-point number or is even smaller. For example, if, like in IEEE-754, a 32 bit floating-point number uses 8 bit for the exponent, the threshold value can be set to 8 or 7 or 6 or smaller values. If the threshold value is reached, the method may comprise using, instead of the above-described steps, a predefined window corresponding to the format of the floating-point number to obtain the floating-point number (i.e. the bits representing the exponent, the sign (optional) and the significand) from the bit stream, starting with the bit at the designated position. With this, it is ensured that the determined exponent has a size that can be represented by the number of bits of the floating-point number that is reserved for the exponent while at the same time ensuring that at least not more bitwise shifts than the number of bits reserved for the exponent has for a given format are performed.

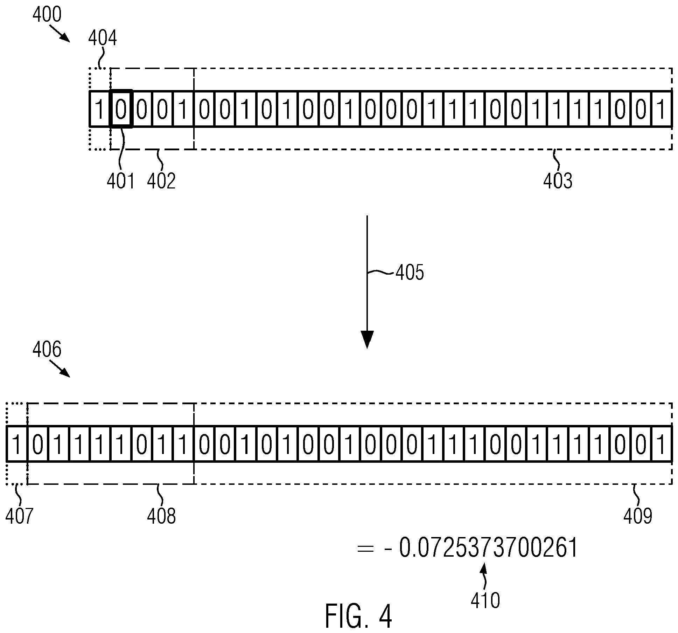

Determining the exponent 106 based on the number of bitwise shifts carried out to obtain a bit having a value of 1 at the designated position of the bit stream can furthermore comprise calculating a difference between the number of bitwise shifts carried out and a bias value. The bias value can, for instance, be specified by the format of the floating-point number to be generated by the method. Determining the exponent 106 can furthermore comprise incrementing the number of bitwise shifts carried out by one and then calculating a difference between the thus obtained value and the bias value. The obtained difference can then be represented in the form appropriate for the floating-point number. For example, if a number b of bitwise shifts is performed, the exponent e can be calculated as $e=127-(b+1)$, where b is the number of bitwise shifts, for a floating-point number represented by the IEEE-754 format and having 32 bit precision with a bias value of 127. The exponent can then be transformed into the corresponding binary notation as explained with reference to the example in Figure 4.

After determining the exponent 106, the method carries out step 107, which comprises determining the significand. The significand is determined based on a certain number of bits of the bit stream that are preferably different from the bits used for determining the exponent. In this way, it can be ensured that no correlation between significand and exponent is present. This is of particular advantage when a bit stream of uniformly distributed binary digits shall be transformed into a sequence of floating-point numbers.

The number of bits used for determining the significand may depend on a format of the floating-point number to be generated by the method. In the preferred embodiment, where the designated position of the bit stream is either specified as the most or least significant position of the bit stream, the bits used for the determination of the significand are the bits immediately subsequent to the bits used for the determination of the exponent, in case the designated position is the most significant position of the bit stream, or the bits directly preceding the bits used for the determination of the exponent, in case the designated position of the bit stream is specified as the least significant position of the bit stream. In one more specific embodiment, the certain number of bits used for the determination of the significand are preferably consecutive bits.

After determining the significand, the method proceeds with the step of transforming the bit stream into a floating-point number 108, by using the previously determined exponent and significand.

Method 100 can also comprise transforming the bit stream into more than one floating-point number by consecutively executing steps 102 to 108. For example, the method may specify a first designated position as the most significant position of the bit stream in step 102. Afterwards, the method carries out a number of bitwise left shifts of the bit stream until a bit having a value of 1 is obtained at the designated position of the bit stream (steps 103 to 105). Afterwards, the method specifies the exponent of the first floating-point number, based on the number of left shifts carried out in step 106. The significand of the first floating-point number is then determined in step 107 based on a first certain number of consecutive bits, (directly) subsequent to the bits used for the determination of the exponent so as to obtain the floating-point number in step 108. Afterwards, the method returns to step 102 and specifies a second designated position of the bit stream, which can, for instance, be the position of the bit stream that is directly subsequent to the certain bits used for the determination of the significand of the first floating-point number. The method then carries out steps 103 to 108 with this new designated position to determine a further floating-point number from the bit stream. In accordance with the procedure detailed above, the method can determine the exponent and the significand of further floating-point numbers from the bit stream, until, for instance, all bits of the bit stream were used by the method.

Optionally, the method may also comprise determining a sign of the floating-point number. The sign bit can, for instance, be specified as the bit that is directly preceding the bit at the designated position of the bit stream. Alternatively, the sign bit may also be located in between the bits used for determining the exponent and the bits used for determining the significand. Also other ways of determining the sign of the floating-point number, which have not been explicitly mentioned above, are possible.

The determining of the sign bit is not particularly represented in the flow diagram of method 100, but may be provided between any of steps 101 to 108. For example, the sign bit may be determined by a step between obtaining the bit stream in step 101 and specifying the designated position in step 102. It can also be determined after step 102 and before step 103. For example, if the bitwise shifts are left shifts, then the sign bit could be set, between steps 102 and 103, as the bit immediately to the left of the designated position. Correspondingly, if the bitwise shifts are right shifts, the sign bit could be selected to be the bit immediately to the right of the designated position.

If the sign bit is determined after having determined the exponent but before determining the significand, it can alternatively or additionally be provided that the sign bit is a bit immediately subsequent (in the direction of the bitwise shifts) to the bits used for determining the exponent. If the sign bit is determined after step 107, then the sign bit may be immediately subsequent (in the direction of the bitwise shifts) to the bits used for determining the significand and the exponent.

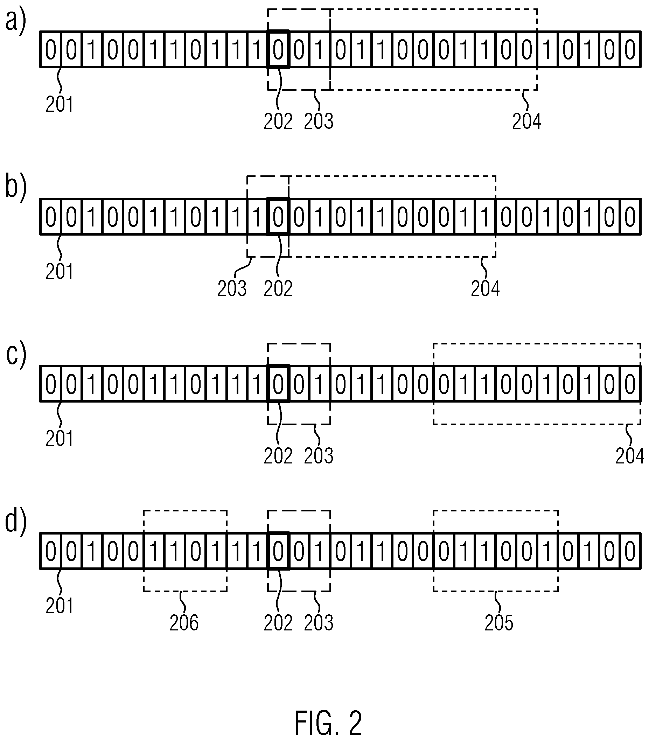

Figures 2a to d indicate different ways of determining the significand and the exponent from a bit stream according to different embodiments of the method described in Figure 1. In these exemplary embodiments, the shown (part of a potentially longer) bit stream has a size of 29 bit and the significand has a precision of 10 bit. The length of the bit stream and the number of bits used for the determination of the significand have to be understood as exemplary.

In the bit stream 201 illustrated in Figure 2a, the bit at the designated position 202 of the bit stream 201 has a value of 0. According to the method, in this case, bitwise shifts of the bit stream are carried out until a bit having a value of 1 is obtained at the designated position 202 of the bit stream 201. In this particular embodiment, the bitwise shifts are left shifts. Two left shifts have to be carried out in order to obtain a bit value of 1 at the designated position of the bit stream, meaning that three bits 203 of the bit stream are involved in determining the exponent of the floating-point number. In this particular embodiment, the bits used for the determination of the significand 204 are chosen as the ten consecutive bits that are directly subsequent to the first bit, subsequent to the bit at the designated position of the bit stream, having a value of 1.

An alternative embodiment is illustrated in Figure 2b, whereby the designated position 202 is identical to the one in the embodiment detailed in Figure 2a. In this embodiment, the bitwise shifts are right shifts. Overall, one right shift of the bit stream has to be carried out in order to obtain a bit value of 1 at the designated position of the bit stream in this example. Consequently, two bits of the bit stream 203 are used in this embodiment for the determination of the exponent. In this embodiment, the bits used for the determination of the significand 204 are the ten consecutive bits that are directly subsequent to the bit at the designated position 202 of the bit stream.

As shown by the alternative embodiment illustrated in Figure 2c, where two bitwise left shifts are carried out, ten consecutive 204 bits that are subsequent but not directly subsequent to the first bit, subsequent to the designated position 202 of the bit stream, having a value of 1, are used for determining the significand. The bits in between could be used for example to determine a sign of the floating-point number or, for example, for dynamically determining the designated position for the determination of a subsequent floating-point number. For example, based on the number of bits with a value of 0 or 1 between the bits used for determining the exponent and the bits used for determining the significand (decremented by 1 if a sign bit is obtained), the distance (in terms of bits) of the designated position (and hence its position in the bit stream) for a subsequent floating-point number to the last bit used for determining the current floating-point number can be determined.

In the embodiment illustrated in Figure 2d, the bit at the designated position 202 of the bit stream has a value of 0. The bitwise shifts are specified as left shifts, whereby, in this example, two left shifts have to be carried out in order to obtain a value of 1 at the designated position of the bit stream. In this particular embodiment, the certain number of bits used for the determination of the significand comprises a first certain number of bits 206 preceding the most significant position of the bit stream and a second certain number of bits 205, subsequent to the first bit, which is subsequent to the bit at the designated position of the bit stream, having a value of 1. The first certain number of bits 206, comprises a number of, for example, four bits that may be separated by two bits from the designated position of the bit stream. The second certain number of bits 205 comprises, for example, a number of 6 bit that may be separated by a number of 5 bit from the first bits used for the determination of the exponent.

It is understood that the first number of bits 206 and the second number of bits 205 together amount to the number of bits of the significand. Let the number of bits for the significand be N, then the relation N=a+b with a being the first number of bits 206 and b being the second number of bits 205 holds. Based on this, for example the second number of bits 205 may be determined based on b=N-a and the first number of bits 206 may be determined, for example, based on the number of bits between the exponent and the first bit of the first number of bits 206 (in the direction opposite to the bitwise shifts) that have a value of 0 or 1. A dynamic determination of the bits used for the exponent is thereby obtained.

The embodiments presented in Figures 2a-d have to be understood as exemplary illustrations of how the exponent and the significand can be determined. In particular, the choice of the designated position of the bit stream is not limited to the bit position of the bit stream, as chosen in Figures 2a-d. In general, any position of the bit stream may be specified as the designated position of the bit stream. In another, here not explicitly illustrated embodiment, the designated position may be the most significant position, the least significant position of the bit stream, or any bit position in between the two just mentioned positions.

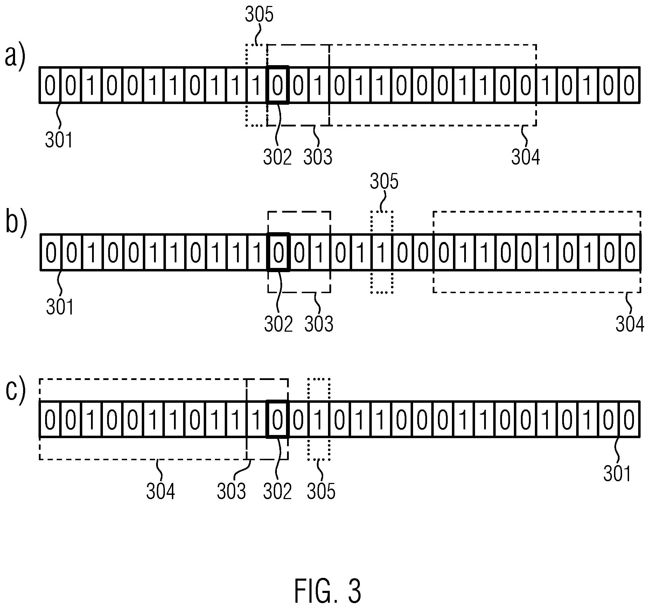

Figures 3a-c illustrate further exemplary embodiments, whereby the bits of a bit stream used for the determination of the sign, the significand and the exponent are indicated. Again, the length of the bit stream and the number of ten bits used for the determination of the significand have to be understood as exemplary.

Figure 3a shows a bit stream 301, where the bit at the designated position 302 of the bit stream has a value of 0. In this embodiment, two left shifts are necessary in order to obtain a bit value of 1 at the designated position 302 of the bit stream. The sign bit 305 is in this embodiment specified as the bit that directly precedes the designated position 302 of the bit stream. The bits used for the determination of the significand 304, are specified as the ten consecutive bits directly subsequent to the first bit having a 1 subsequent to the designated position 302 of the bit stream.

As shown in Figure 3b, the sign bit 305 may, however, also be located in between the bits used for the determination of the exponent 303 and the bits used for the determination of the significand 304. In this particular embodiment, the bits used for the determination of the exponent, the sign and the significand are not consecutive, but separated by a certain number of bits.

An alternative embodiment is illustrated in Figure 3c, where a single right shift has to be carried out in order to obtain a bit at the designated position 302 of the bit stream having a value of 1, meaning that two bits 303 are used for the determination of the exponent. The bits used for the determination of the significand 304 are directly preceding the bits used for the determination of the exponent 302. The bit used for the determination of the sign 305 of the floating-point number is located at a position subsequent to the designated position of the bit stream, whereby a single bit separates the designated position 302 and the sign bit 305.

Neither the direction and number of the bitwise shifts performed nor the number of bits between the bits used for the exponent, the sign and the significand are limiting. The embodiments of Figures 3a to 3c are thus only exemplarily in this respect.

An exemplary transformation 405 of a bit stream 400 into a floating-point number 406, according to a preferred embodiment of the method detailed in Figure 1, is illustrated in Figure 4.

In this embodiment, the bit stream 400 is transformed into a single floating-point number 406 with a precision of 32 bit according to the IEEE-754 standard. In the case of a single precision floating-point number, 1 bit is reserved for the sign bit, 8 bit are reserved for the exponent and 23 bit are reserved for the significand.

The exemplary portion of the bit stream used to determine the floating-point number by the method comprises 28 bit. It is understood that the whole bit stream is not depicted here and may comprise more bits. Particularly, the bit stream may have a total size of some $10^9$ or $10^{12}$ bit not depicted here for ease of explanation. The designated position 401 may thus be any position within the bit stream, not necessarily the most significant bit of the bit stream. Preferably, the bit stream comprises uniformly distributed random bits, which may, for instance, be obtained from a physical random bit generator. In this specific embodiment, the bit at the designated position 401 of the bit stream 400 has a value of 0. The sign bit 404 is specified as the bit that is directly preceding the bit at the designated position 401 of the bit stream 400, though not being limiting to the invention and any other embodiment for determining the sign bit (like the ones described in relation to Figures 3a to 3c) can be used. In this embodiment the sign bit has a value of 1 in binary representation. In order to obtain a bit having a value of 1 at the designated position 401 of the bit stream, three bitwise left shifts have to be carried out in the example shown. Consequently, four bits 402 are used to determine the exponent. In this embodiment, the exponent of the floating-point number is then determined by incrementing the number of bitwise left shifts carried out, which equals three, by one and subtracting the thus obtained value of 4 from a constant bias value of 127, as specified by the single precision format according to the IEEE-754 standard of the floating-point number to be generated. The exponent determined by the method according to this specific embodiment therefore corresponds to a value of 123 in decimal notation, which translates to a value of 1111011 in binary representation. In a 8 bit binary representation, as used for the representation of the exponent of the single precision floating-point number to be generated by the method according to this embodiment, this value reads as 01111011, as shown in 408. In this embodiment, the significand of the floating-point number is determined by using the 23 consecutive bits that are directly subsequent to the bits of the bit stream used for determining the exponent, as shown in 403. The significand therefore corresponds to a value of 00101001000111001111001 in binary notation. Based on the thus determined sign, exponent and significand, the bit stream 400 is then transformed 405 into a single precision floating-point number in the IEEE-754 representation 406. Here, item 407 represents the sign bit, item 408 the exponent and item 409 the significand. This number can also be represented in the decimal notation 410.

In this preferred embodiment, the number of bits consumed from the bit stream is, at 28 bit, lower than the precision of 32 bit of the floating-point into which the bit stream is being transformed. Thus, the number of bits used from the random bit stream to obtain a random floating-point number with 32 bit precision is less than 32 bit. By consecutively carrying out this method, the amount of 32 bit floating-point numbers that can be obtained from a bit stream with given length (for example $10^9$ bit) is thus, on average, larger than the number of floating-point numbers with the same precision that could be obtained if the bit stream would only be processed by consecutive windows of 32 bit size, thereby allowing obtaining more random numbers from a bit stream having a given size.

**Claims**

1. Computer-implemented method comprising obtaining a bit stream (101) and transforming the bit stream into a floating-point number (108), wherein the floating-point number comprises an exponent and a significand, the transformation comprising determining the exponent (106) of the floating-point number based on counting a number of bitwise shifts needed to obtain a bit value of 1 at a designated position of the bit stream, the transformation further comprising determining the significand (107) of the floating-point number based on a certain number of bits that are different from the bits used for determining the exponent.

2. Computer-implemented method according to claim 1, wherein the certain number of bits comprises bits preceding the bit at the designated position of the bit stream or the certain number of bits comprises bits subsequent to the first bit, starting from the designated position of the bit stream, having a value of 1.

3. Computer-implemented method according to claim 1 or 2, wherein, the bitwise shifts are left shifts and wherein the certain number of bits comprises bits immediately preceding the bit at the designated position of the bit stream or the certain number of bits comprises bits immediately subsequent to the first bit, starting from the designated position of the bit stream, having a value of 1; or wherein the bitwise shifts are right shifts and wherein the certain number of bits comprises bits immediately subsequent to the bit at the designated position of the bit stream or the certain number of bits comprises bits immediately preceding the first bit, starting from the designated position of the bit stream, having a value of 1.

4. Computer-implemented method according to claim 1, wherein the certain number of bits comprises a first certain number of bits preceding the bit at the designated position of the bit stream and a second certain number of bits subsequent to the first bit, starting from the designated position of the bit stream, having a value of 1.

5. Computer-implemented method according to any of the claims 1 to 4, wherein the value of the exponent is a given fixed value in case the number of bitwise shifts equals a threshold value.

6. Computer-implemented method according to any of the claims 1 to 5, wherein the floating-point number comprises a sign.

7. Computer-implemented method according to claim 6, wherein the transformation comprises determining the sign of the floating-point number based on a value of a sign bit preceding the bit at the designated position of the bit stream or subsequent to the first bit, starting from the designated position of the bit stream, having a value of 1.

8. Computer-implemented method according to claim 7, wherein the sign of the floating-point number is positive in case the value of the sign bit is a 0 and negative in case the value of the sign bit is a 1 or, wherein the sign of the floating-point number is positive in case the value of the sign bit is a 1 and negative in case the value of the sign bit is a 0.

9. Computer-implemented method according to any of the claims 1 to 8, wherein determining the exponent further comprises determining a difference between the number of bitwise shifts and a bias value.

10. Computer-implemented method according to any of the claims 1 to 9, wherein determining the exponent further comprises incrementing the number of bitwise shifts needed by one.

11. Computer-implemented method according to any of the claims 1 to 10, wherein the number of bits of the bias value depends on a format of the floating-point number.

12. Computer-implemented method according to any of claims 1 to 11, wherein the certain number of bits used to determine the significand depends on the format of the floating-point number.

13. Computer-implemented method according to any of the claims 1 to 12, wherein a size of the floating-point number is a half, a single, a double, a quadruple or an octuple.

14. Computer-implemented method according to any of the claims 1 to 13, wherein the format of the floating-point number is a minifloat or a bFloat.

15. Computing system adapted to execute a computer-implemented method according to any of claims 1 to 14.

FIG. 1

a)

0 0 1 0 0 1 1 0 1 1 **0** 0 1 0 1 1 0 0 0 1 1 0 0 1 0 1 0 0

201    202 203                    204

b)

0 0 1 0 0 1 1 0 1 1 **0** 0 1 0 1 1 0 0 0 1 1 0 0 1 0 1 0 0

201    203 202                    204

c)

0 0 1 0 0 1 1 0 1 1 **0** 0 1 0 1 1 0 0 0 1 1 0 0 1 0 1 0 0

201    202 203                    204

d)

0 0 1 0 0 1 1 0 1 1 **0** 0 1 0 1 1 0 0 0 1 1 0 0 1 0 1 0 0

201    206    202 203        205

FIG. 2

FIG. 3

400

404

401 402

403

405

406

407 408

409

$= -0.0725373700261$

410

FIG. 4

| | Europäisches Patentamt European Patent Office Office européen des brevets | **EUROPEAN SEARCH REPORT** | Application Number EP 22 38 2683 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/091786 A1 (FELIX STEPHEN [GB] ET AL) 25 March 2021 (2021-03-25)<br>* paragraph [0005] *<br>* paragraph [0062] – paragraph [0086]; figure 8 *<br>───── | 1-15 | INV.<br>G06F7/483<br>G06F7/58 |
| A | THOMAS D B ET AL: "Resource efficient generators for the floating-point uniform and exponential distributions", APPLICATION-SPECIFIC SYSTEMS, ARCHITECTURES AND PROCESSORS, 2008. ASAP 2008. INTERNATIONAL CONFERENCE ON, IEEE, PISCATAWAY, NJ, USA,<br>2 July 2008 (2008-07-02), pages 102-107, XP031292384,<br>ISBN: 978-1-4244-1897-8<br>* section 2 *<br>───── | 1-15 | |
| A | US 2020/201602 A1 (FELIX STEPHEN [GB] ET AL) 25 June 2020 (2020-06-25)<br>* paragraph [0084] – paragraph [0097] *<br>───── | 1-15 | |

**TECHNICAL FIELDS SEARCHED (IPC)**

G06F

The present search report has been drawn up for all claims

| Place of search | Date of completion of the search | Examiner |
|---|---|---|
| Munich | 15 December 2022 | Tenbieg, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 38 2683

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2022

| Patent document cited in search report | | Publication date | Patent family member(s) | | Publication date |
|---|---|---|---|---|---|
| US 2021091786 | A1 | 25-03-2021 | CN | 113168310 A | 23-07-2021 |
| | | | EP | 3847544 A1 | 14-07-2021 |
| | | | GB | 2580160 A | 15-07-2020 |
| | | | JP | 2022513300 A | 07-02-2022 |
| | | | KR | 20210103552 A | 23-08-2021 |
| | | | US | 2021091786 A1 | 25-03-2021 |
| | | | WO | 2020126124 A1 | 25-06-2020 |
| US 2020201602 | A1 | 25-06-2020 | GB | 2580153 A | 15-07-2020 |
| | | | US | 2020201602 A1 | 25-06-2020 |

EPO FORM P0459

For more details about this annex : see Official Journal of the European Patent Office, No. 12/82